(19)

Europäisches
Patentamt
European
Patent Office
Office européen
des brevets

(11) **EP 2 051 390 A2**

(12) **EUROPEAN PATENT APPLICATION**

(43) Date of publication:
**22.04.2009 Bulletin 2009/17**

(51) Int Cl.:
*H04B 1/04* (2006.01)  *H03F 1/32* (2006.01)

(21) Application number: **08163606.0**

(22) Date of filing: **03.09.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **01.05.2008 JP 2008119473**
**18.10.2007 JP 2007271270**

(71) Applicant: **Fujitsu Limited**
**Kawasaki-shi, Kanagawa 211-8588 (JP)**

(72) Inventors:
• **Susuki, Kenji**
**Kawasaki-shi, Kanagawa 211-8588 (JP)**

• **Tsuchiya, Toshikazu**
**Kawasaki-shi, Kanagawa 211-8588 (JP)**
• **Satou, Michiko**
**Kawasaki-shi, Kanagawa 211-8588 (JP)**
• **Toyomane, Akira**
**Kawasaki-shi, Kanagawa 211-8588 (JP)**

(74) Representative: **Stebbing, Timothy Charles**
**Haseltine Lake**
**5th Floor Lincoln House**
**300 High Holborn**
**London, WC1V 7JH (GB)**

(54) **A radio transmission apparatus**

(57)    A radio transmission apparatus employing predistortion does not update the distortion compensation coefficient for a certain period, which is shorter than the transmission period, after the transmission period start timing. Instead, update operation of the distortion compensation coefficient is carried out after the lapse of a certain period from the start timing, thus avoiding, for example, switching-induced fluctuations at the start of the transmission period in a TDD system. Further, in order to shorten the convergence time of the distortion compensation coefficient, the radio transmission apparatus performs interpolation processing of the distortion compensation coefficient. The distortion compensation coefficient is given to a two-dimensional coordinate (address) : one co-ordinate is the power level of an input transmission signal and the other is the difference of power between the input transmission signal and a feedback signal. The distortion compensation coefficient at a predetermined coordinate is updated to an interpolated value, which is obtained through interpolation calculation using the distortion compensation coefficient at a coordinate adjacent to the predetermined coordinate.

FIG. 2

EP 2 051 390 A2

Printed by Jouve, 75001 PARIS (FR)

**Description**

This application is based upon and claims the benefit of priority from the prior Japanese Patent Application No. 2007-271270, filed on October 18, 2007, and the prior Japanese Patent Application No. 2008-119473, filed on May 1, 2008.

The present invention relates to a radio transmission apparatus performing distortion compensation processing using a distortion compensation coefficient, and more particularly to a radio transmission apparatus performing distortion compensation processing upon a transmission signal, particularly but not exclusively in a time division duplex (TDD) transmission scheme.

As a low noise amplifier for use in a power amplifier for amplifying a linearly modulated signal and a receiver unit for a linearly modulated signal, an amplifier having high linearity is required to suppress deterioration in a spectral characteristic and a transmission characteristic caused by signal distortion.

In particular, when a multilevel amplitude modulation scheme is applied to radio communication, a technique is required on the transmission side to suppress nonlinear distortion and reduce adjacent channel leakage power by linearizing the amplification characteristic of the power amplifier. Further, although high power efficiency is generally required for the amplifier, the linearity and efficiency in the amplifier are in general conflicting characteristics. When it is intended to improve power efficiency using an amplifier having inferiority in linearity, it is an essential technique to compensate the distortion produced thereby.

As one such distortion compensation scheme, a predistortion scheme is known. The principle of the predistortion scheme is to obtain a desired signal having no distortion in an amplifier output by adding beforehand an inverse characteristic of the amplifier distortion characteristic to an amplifier input signal. As to the predistortion scheme, for example, detailed descriptions have been given in the following patent documents 1, 2, 3 and 4.

A transmission signal before distortion compensation is compared with a demodulated feedback signal, and using the error thereof, a distortion compensation coefficient is calculated and updated. The distortion compensation coefficient is stored into a memory of which the address is determined by the amplitude or the power of the transmission signal, or the function thereof. Then, using the updated distortion compensation coefficient, predistortion is applied to a transmission signal which is to be transmitted next, and the processing result is output. By repeating the above process, finally, the result converges on an optimum distortion compensation coefficient. The distortion in the transmission power amplifier is compensated accordingly.

[Patent document 1] The Japanese Unexamined Patent Publication No. Hei-9-153849
[Patent document 2] The Japanese Unexamined Patent Publication No. 2002-223171
[Patent document 3] The Japanese Unexamined Patent Publication No. 2006-197537
[Patent document 4] The Japanese Unexamined Patent Publication No. 2006-74539

Meanwhile, in recent years, in addition to the transmission systems most commonly used at present, such as 3G, which realize simultaneous transmission and reception by FDD (Frequency Division Duplex), TDD (Time Division Duplex) schemes such as some implementations of WiMAX are being put into practical use for radio communication.

When the conventional predistortion is performed on a transmission signal in a TDD radio communication system, transmission and reception is switched at high speed. Accordingly, an abrupt (transient) bias current flows in a power amplifier immediately after the start of a transmission period. This produces fluctuation in the amplitude and phase component immediately after the rise of the transmission signal. As a result, a relatively large error becomes included in an updated distortion compensation coefficient. This makes it impossible to calculate a correct distortion compensation coefficient, which causes a problem that a sufficient distortion compensation effect is not obtained.

Further, in WiMAX systems using TDD, in the case of transmitting through a full subcarrier, the transmission level of the top symbol (preamble) of the transmission signal becomes approximately 3 dB greater than the transmission level of a data symbol period. This produces a narrower linear region. As a result, a larger error in the distortion compensation coefficient is produced, and thereby correct distortion compensation operation is impeded.

Also, in the case of the TDD scheme, the transmission period and the reception period are switched alternately. The distortion compensation coefficient is not updated during the reception period. If the distortion compensation coefficient is updated only during the transmission period, a longer time is required for the convergence of the distortion compensation coefficient, as compared to the case of the FDD scheme.

Further, in a WiMAX TDD system, the number of transmission subcarriers of the transmission signals of the WiMAX system varies symbol-by-symbol. This causes a fluctuated transmission power level in each symbol period. In some cases, the transmission level is varied after the distortion compensation coefficient at a certain transmission level is calculated. This makes it difficult to obtain an optimal distortion compensation coefficient at all times. Therefore, it is necessary to shorten the convergence time of the distortion compensation coefficient, and to obtain a faster processing speed.

Accordingly, it is desirable to provide a radio transmission apparatus, capable of reducing a distortion compensation coefficient error and shortening the convergence time of the distortion compensation coefficient.

In a time division duplex (TDD) radio communication system, for example, a correct distortion compensation coefficient cannot be calculated because of large fluctuations in the amplitude and phase components immediately after the start timing of the transmission period. Accordingly, the radio communication apparatus does not update the distortion compensation coefficient for a certain period, which is shorter than the transmission period, after the transmission period start timing. Instead, update operation of the distortion compensation coefficient is carried out after the lapse of a certain period from the start timing. Additionally, distortion compensation operation on the transmission signal is performed during a certain period from the transmission period start timing in which no update operation is carried out.

Further, in order to shorten the convergence time of the distortion compensation coefficient, the radio transmission apparatus performs interpolation processing of the distortion compensation coefficient. The distortion compensation coefficient is given to a two-dimensional coordinate (address): one is the power level of an input transmission signal and the other is the difference of power between the input transmission signal and a feedback signal. The distortion compensation coefficient at a predetermined coordinate is updated to an interpolated value, which is obtained through interpolation calculation using the distortion compensation coefficient at a coordinate adjacent to the predetermined coordinate.

Further, in the transmission period, the radio transmission apparatus is made to vary a predetermined timing for starting the update processing of the distortion compensation coefficient on the basis of each transmission period.

As such, update processing of the distortion compensation coefficient is not performed for a certain period after the transmission period start timing, in the case of a time division duplex (TDD) system. Instead, the update operation of the distortion compensation coefficient is performed after the lapse of a certain time. Accordingly, it is possible to avoid the update of the distortion compensation coefficient in a period having large fluctuations in the amplitude and phase of the transmission signal. Thus, an increased distortion compensation coefficient error is prevented, and normal distortion compensation operation can be maintained accordingly.

Further, an interpolation calculation is carried out on a predetermined distortion compensation coefficient to be stored into a memory, using a distortion compensation coefficient which is adjacent in the memory to the distortion compensation coefficient of interest. An interpolated value of the predetermined distortion compensation coefficient is obtained, so as to be updated to the above interpolated value. Thus, it is possible to shorten the convergence time of the distortion compensation coefficient.

Further features and effects of the present invention will become more apparent by the following description of the embodiments with the accompanied drawings, in which:-

FIG. 1 is a diagram illustrating a first exemplary configuration of a radio transmission apparatus according to the present embodiment;
FIG. 2 is a timing chart of a distortion compensation timing controller 33 in the apparatus of Figure 1;
FIG. 3 is a diagram illustrating mapping configurations of a distortion compensation coefficient;
FIG. 4 is a diagram illustrating mapping configurations of the distortion compensation coefficient;
FIG. 5A shows distortion compensation coefficients before interpolation stored in memory (LUT) 42, and FIG. 5B shows distortion compensation coefficients after the interpolation to be stored in memory (LUT) 42;
Fig. 6 is a diagram illustrating a timing chart of update processing and interpolation processing of the distortion compensation coefficient in the TDD scheme;
FIG. 7 is a diagram illustrating a timing chart of the update processing and the interpolation processing of the distortion compensation coefficient in the FDD scheme in which continuous transmission is carried out;
FIG. 8 is a diagram illustrating a second exemplary configuration of the radio transmission apparatus according to the present embodiment;
FIG. 9 is a diagram illustrating a third exemplary configuration of the radio transmission apparatus according to the present embodiment;
FIG. 10A and 10B are diagrams illustrating a timing chart of the timing adjustment processing in the third exemplary configuration;
FIG. 11 is a processing flowchart of timing adjuster 14; and
FIG. 12 shows distortion compensation coefficients updated shown in the third exemplary configuration.

Hereafter, the preferred embodiment of the present invention will be described with reference to the charts and drawings. However, the described embodiment does not limit the technical scope of the present invention; for example the present invention is not limited to use with a radio communication system employing the TDD mode.

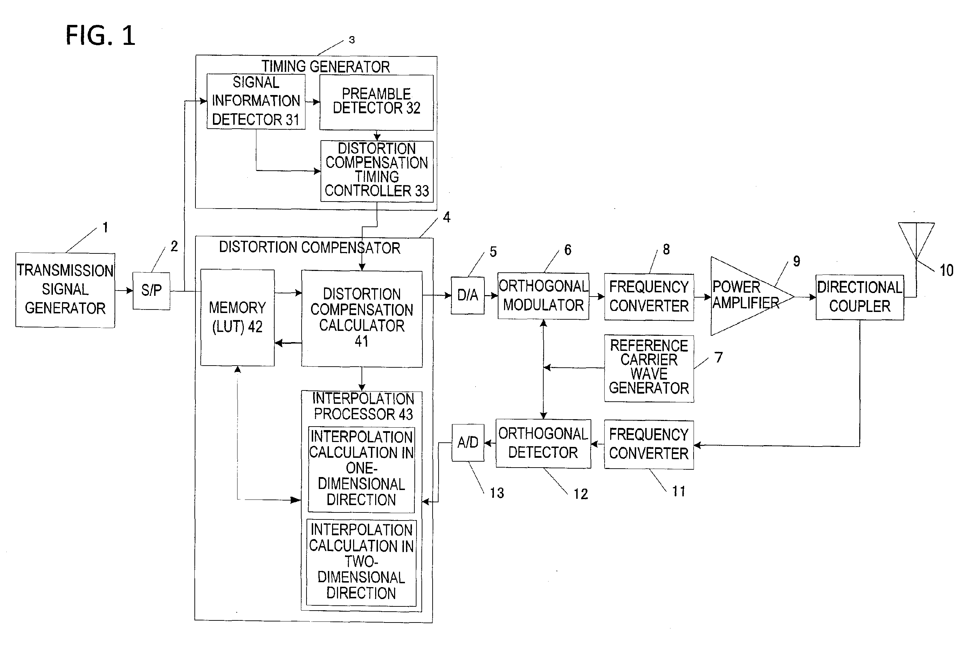

FIG. 1 is a diagram illustrating a first exemplary configuration of a radio transmission apparatus according to the present embodiment. A transmission signal generator 1 transmits a serial digital data string. A serial/parallel converter (S/P) 2 performs serial/parallel conversion of the serial digital data string, so as to convert into an I signal and Q signal parallel data string.

A timing generator 3 generates a timing at which to start updating a distortion compensation coefficient, this timing being after a lapse of a certain period from transmission period start timing, and also generates a timing at which to complete the update of the distortion compensation coefficient, which may occur at transmission period end timing. More specifically, a signal information detector 31 in timing generator 3 detects map information (information indicative of a data position) of the transmission signal from the parallel data string. From the map information and switchover timing between a transmission period and a reception period stored in advance, a preamble detector 32 obtains the transmission period of a top symbol (preamble) in the transmission signal. Then, a distortion compensation timing controller 33 outputs a distortion compensation update timing signal to a distortion compensator 4 (making a distortion compensation update timing signal ON) at preamble transmission end timing. Also, distortion compensation timing controller 33 makes the distortion compensation update timing signal OFF at the transmission period end timing to complete the update of the distortion compensation. With regard to distortion compensation operation, distortion compensation timing controller 33 outputs to distortion compensator 4 a timing signal to start the distortion compensation operation at the transmission period start timing (making a distortion compensation operation timing signal ON) . Also, distortion compensation timing controller 33 makes the distortion compensation operation timing signal OFF at the transmission period end timing. Namely, although the distortion compensation operation is performed in the period from the transmission period start timing to the preamble transmission end timing, the distortion compensation is not updated because the period has large fluctuations in the amplitude and phase of the transmission signal. Here, the period in which the distortion compensation is not updated is not limited to the transmission period start timing to the preamble transmission end timing, but can properly be modified depending on the state of fluctuations in the amplitude and phase of the transmission signal. In a WiMAX system using TDD, the transmission level in the top symbol (preamble) of the transmission signal is approximately 3 dB greater than the transmission level in a data symbol period, by which a conspicuous error may occur easily. Therefore, as one example of the period in which the distortion compensation is not updated, the period from the transmission period start timing to the preamble transmission end timing is exemplified above.

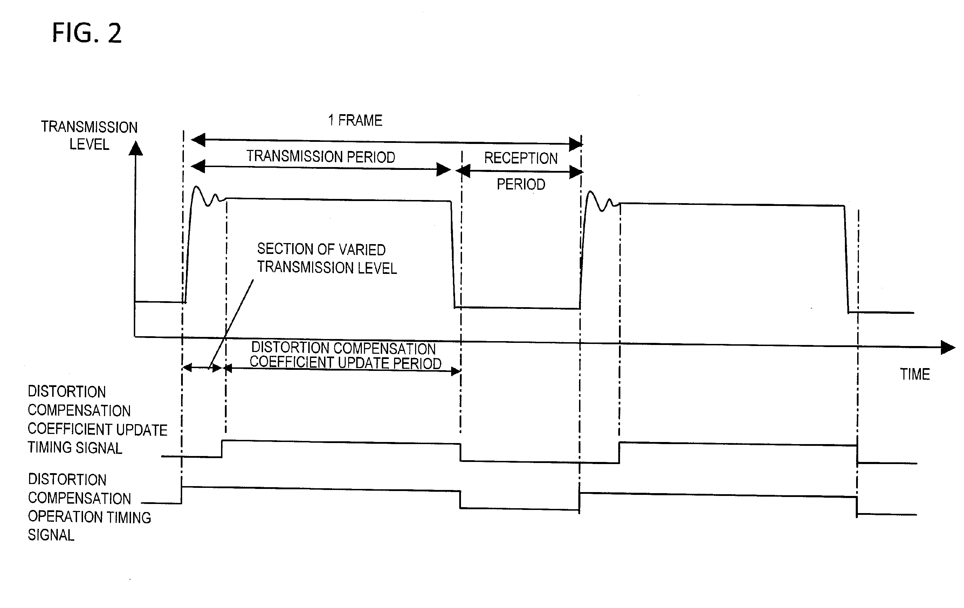

FIG. 2 is a timing chart of distortion compensation timing controller 33 in the case of TDD-mode communication, wherein each frame is divided in the time domain into a transmission period and a reception period. Distortion compensation timing controller 33 outputs the distortion compensation operation timing signal at the transmission period start timing. With regard to the distortion compensation update timing signal to start the update of the distortion compensation, distortion compensation timing controller 33 outputs the above timing signal after the lapse of a certain period from the transmission period start timing (i. e. at the preamble transmission end timing). With this, the distortion compensation coefficient is not obtained in the period immediately after the start of the transmission period in which the amplitude and phase of the transmission signal greatly fluctuate. Thus, it is possible to exclude the period which causes an error in the distortion compensation coefficient, due to the influence of the greatly fluctuating amplitude and phase of the transmission signal, immediately after the start of the transmission period. Further, because the distortion compensation coefficient is obtained and updated at a stage when the amplitude and phase of the transmission signal are stabilized, a correct distortion compensation coefficient can be obtained. Thus, the distortion characteristic deterioration in the transmission signal can be suppressed to the minimum. Also, at the transmission period end timing, distortion compensation timing controller 33 makes the distortion compensation operation timing signal OFF, and also the distortion compensation coefficient update timing signal OFF, so as to suspend the update of the distortion compensation coefficient in the reception period. Thus, the distortion compensation coefficient can be prevented from being broken, or in other words maintained until the next frame.

Referring back to FIG. 1, distortion compensator 4 performs distortion compensation operation on the parallel data string (transmission signal) constituted of the I signal and the Q signal by the above-mentioned distortion compensation operation start timing signal. Also, distortion compensator 4 completes the distortion compensation operation by the distortion compensation operation end timing signal. Further, distortion compensator 4 starts updating the distortion compensation coefficient by the distortion compensation update start timing signal, and suspends the update of the distortion compensation coefficient by the distortion compensation update end timing signal. A distortion compensation calculator 41 reads out fromamemory (LUT) 42 the distortion compensation coefficient corresponding to an input transmission signal power level. Distortion compensation calculator 41 then performs predetermined calculation processing on the transmission signal using the read distortion compensation coefficient, and outputs the result thereof. Memory (LUT) 42 stores the distortion compensation coefficient corresponding to a two-dimensional coordinate constituted of a transmission signal power level and a power difference between a transmission signal and a feedback signal (for example, the transmission signal at the present time and the feedback signal of the transmission signal at the previous time). Also, based on the power difference between the transmission signal and the feedback signal, distortion compensation calculator 41 calculates a distortion compensation coefficient corresponding to the input transmission signal power, and updates the distortion compensation coefficient stored in memory (LUT) 42. According to the embodiment of the present invention, with regard to the distortion compensation coefficient obtained by distortion compensation calculator 41, interpolation calculation is performed in an interpolation processor 43. Then, the distortion compensation coefficient obtained through the above interpolation calculation is stored into memory (LUT) 42. The interpolation calculation will be described in detail later.

The distortion-compensated transmission signal output from distortion compensator 4 is input into an orthogonal modulator 6 through a D/A converter 5. Orthogonal modulator 6 performs orthogonal modulation by adding the results of multiplying the input transmission signal and a 90° phase-shifted transmission signal respectively by reference carrier waves from a reference carrier wave generator 7.

A frequency converter 8 converts the transmission signal into a radio frequency signal by mixing the orthogonally modulated signal with a local oscillator signal. After being amplified in a power amplifier 9, the radio frequency signal is transmitted using time division duplex. Also, the transmission signal is looped back inside the radio transmission apparatus through a directional coupler. After being converted into an IF signal by means of a frequency converter 11 and an orthogonal detector 12, the above signal is passed through an A/D converter 13, and fed back to distortion compensator 4 as a feedback signal.

Distortion compensation update processing to be performed in distortion compensator 4 includes calculation processing based on the transmission signal and the feedback signal, calculation of the distortion compensation coefficient, and periodical update processing. Since the transmission period and the reception period alternate in the TDD scheme, the time available for updating the distortion compensation coefficient is short. As a result, a long time is needed before the coefficient is converged. To cope with the above problem, interpolation calculation processing of the distortion compensation coefficient is performed in interpolation processor 43 of distortion compensator 4, so as to make the convergence time faster and stabilize the coefficient. The interpolation calculation processing of the distortion compensation coefficient will be described in the following.

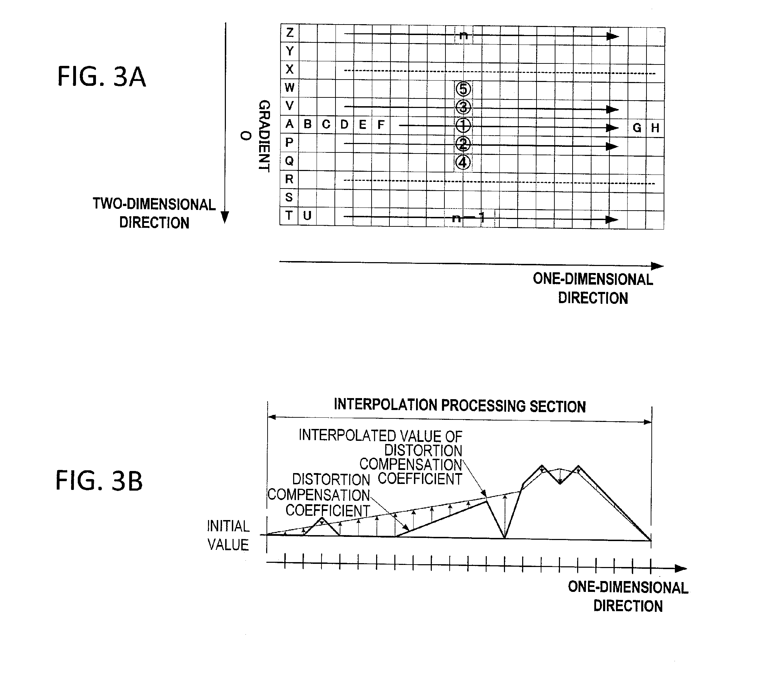

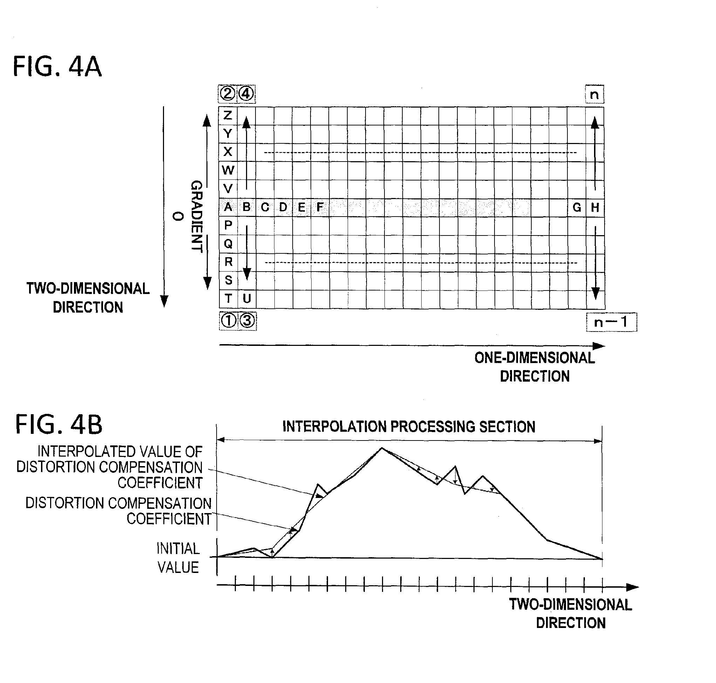

FIGS. 3A through 4B are diagrams explaining interpolation processing of the distortion compensation coefficient. In the interpolation processing, the distortion compensation coefficient at each coordinate stored in memory (LUT) 42 is updated after interpolation calculation is performed using the distortion compensation coefficients at the adjacent coordinates. The memory coordinate is synonymous with an address to identify the location in the memory. FIGS. 3A, 3B are diagrams explaining the interpolation processing in a one-dimensional direction, while FIGS. 4A, 4B are diagrams explaining the interpolation processing in a two-dimensional direction. FIG. 3A and FIG. 4A are diagrams illustrating mapping configurations of the distortion compensation coefficient stored in memory (LUT) 42. In each diagram, a variable in the one-dimensional direction represents a transmission signal power value, and a variable in the two-dimensional direction represents a power difference between a transmission signal and a feedback signal. A "gradient 0" in the variable of the two-dimensional direction represents a case that the power difference is zero, namely, a case that the power values between the transmission signal and the feedback signal (for example, between the transmission signal at the present time and the feedback signal of the transmission signal at the previous time) are identical. Above or below the row of gradient 0 indicates a plus (+) direction of the power difference (i.e. the transmission signal power > the feedback signal power), or a minus (-) direction (i.e. the transmission signal power < the feedback signal power) respectively. FIG. 3B shows distortion compensation coefficients corresponding to variables in the one-dimensional direction when the variable in the two-dimensional direction (power difference) has a predetermined value. Also, FIG. 4B shows distortion compensation coefficients corresponding to variables in the two-dimensional direction when the variable in the one-dimensional direction (transmission signal power value) has a predetermined value. The initial value of the distortion compensation coefficient is "1+j0" (complex notation).

In the interpolation processing of the one-dimensional direction, interpolation calculation is performed for a coordinate to be interpolated (for example, B in FIG. 3A), using a distortion compensation coefficient at the coordinate of interest before interpolation and distortion compensation coefficients at the coordinates (A and C in FIG. 3A) adjacent to the coordinate of interest in the one-dimensional direction. Thus, with regard to the coordinate to be interpolated, the distortion compensation coefficient after the interpolation calculation is obtained. As an example, an interpolation calculation expression is given by expression (1) shown below. Here, in expression (1), each distortion compensation coefficient at each coordinate A, B, C is also represented as A, B, C.

$$B' = \frac{M-1}{M}B + \frac{A+C}{2M} \quad \cdots \quad (1)$$

where

B': distortion compensation coefficient at the coordinate B after interpolation calculation (which is also referred to as interpolated value)

B: distortion compensation coefficient at the coordinate B before interpolation calculation
A: distortion compensation coefficient at the coordinate A adjacent to the coordinate B in the one-dimensional direction
C: distortion compensation coefficient at the coordinate C adjacent to the coordinate B in the one-dimensional direction
M: interpolation coefficient

For example, in case the interpolation coefficient M=3,

$$B' = (4B + A + C) / 6$$

is obtained. Namely, the distortion compensation coefficient at the coordinate B is obtained through the interpolation calculation of the ratio 2/3 of the distortion compensation coefficient at the coordinate B before the interpolation calculation, the ratio 1/6 of the distortion compensation coefficient at the coordinate A, and the ratio 1/6 of the distortion compensation coefficient at the coordinate C.

Subsequent to the coordinate B, with regard to the coordinate C, interpolation calculation in the one-dimensional direction using the above expression (1) is performed, using the distortion compensation coefficients at the both adjacent coordinates B and D, so as to obtain the interpolated value of the coordinate C. Subsequently, interpolation calculations are successively performed with regard to the coordinates adjacent to the right.

Additionally, when the distortion compensation coefficient at an adjacent coordinate is unchanged from the initial value, instead of the above coefficient, a distortion compensation coefficient at a coordinate not having the initial distortion compensation coefficient value in the one-dimensional direction is used. For example, in FIG. 3A, to obtain an interpolated value of the coordinate C, if the distortion compensation coefficient at the coordinate D has an initial value and the distortion compensation coefficient at the coordinate E adjacent to the coordinate D in the one-dimensional direction has no initial value, the distortion compensation coefficient at the coordinate E is used in place of the distortion compensation coefficient at the coordinate D. In other words, the "adjacent coordinate" in expression (1) signifies a coordinate nearest to the coordinate to be interpolated on the either side thereof in the one-dimensional direction, among the coordinates not having the initial distortion compensation coefficient values in the one-dimensional direction. Exceptionally, with regard to the coordinate at either end in the one-dimensional direction (for example, the coordinate A, H in FIG. 3A), the distortion compensation coefficient is used intact even when the initial value is left unchanged. (As described above, in the interpolation calculation for the coordinate B, even if the coordinate A has the initial value, the interpolated value of the coordinate B is calculated using the above initial value). Also, with regard to the coordinate on the either end in the one-dimensional direction (for example, the coordinate A, H shown in FIG. 3A), interpolation calculation in the one-dimensional direction is not performed.

The interpolation calculations in the one-dimensional direction are carried out successively from the left end side (excluding the coordinates on both ends) of a row having a value in the two-dimensional direction of 0 (gradient 0). More specifically, by proceeding to the right direction from the coordinate B, the interpolation calculations are completed up to the last coordinate (G) excluding the coordinate (H) on the right end. Then, with regard to the row lower by one than the row having the gradient 0, the interpolation calculations are carried out from the left end side toward the right end side. Subsequently, after being shifted to the row upper by one than the row having the gradient 0, the interpolation calculations are continued. As such, the interpolation calculations are alternately performed for the rows in the plus direction and the minus direction, with the row having the gradient 0 as a center.

FIG. 3B shows distortion compensation coefficients in the one-dimensional direction at a predetermined value in the two-dimensional direction and the interpolated values (distortion compensation coefficients after interpolation) thereof. As shown in the figure, through the above-mentioned interpolation calculations, smoothing processing is carried out on distortion compensation coefficients which are liable to include a prominent error, as compared to the distortion compensation coefficients at the adjacent coordinates. Thus, values nearer to the convergence value can be obtained.

In the two-dimensional direction also, the interpolation processing similar to the interpolation processing in the one-dimensional direction is performed. In FIG. 4A, with regard to the distortion compensation coefficient at a coordinate to be interpolated (for example, P in FIG. 4A), the interpolation calculations are performed using the distortion compensation coefficient at the coordinate concerned before the interpolation and distortion compensation coefficients at the coordinates (A, Q in FIG. 4A) adjacent to the coordinate concerned in the two-dimensional direction. Thus, distortion compensation coefficients after interpolation calculations are obtained for the coordinate to be interpolated. An expression for interpolation calculation is given, for example, by the following expression (2). Here, in expression (2), the distortion compensation coefficient at each coordinate A, P, Q is also represented as A, P, Q.

$$P' = \frac{N-1}{N}P + \frac{A+Q}{2N} \quad \cdots \quad (2)$$

where

P': distortion compensation coefficient at the coordinate B after interpolation calculation (which is also referred to as interpolated value)

P: distortion compensation coefficient at the coordinate B before interpolation calculation

A: distortion compensation coefficient at the coordinate A adjacent to the coordinate B in the one-dimensional direction

Q: distortion compensation coefficient at the coordinate C adjacent to the coordinate B in the one-dimensional direction

N: interpolation coefficient

For example, in case the interpolation coefficient N=3,

$$P' = (4P+A+Q) / 6$$

is obtained. Namely, the distortion compensation coefficient at the coordinate P is obtained through the interpolation calculation of the ratio 2/3 of the distortion compensation coefficient at the coordinate P before the interpolation calculation, the ratio 1/6 of the distortion compensation coefficient at the coordinate A, and the ratio 1/6 of the distortion compensation coefficient at the coordinate Q.

Subsequent to the coordinate P, interpolation calculation with regard to the coordinate Q in the two-dimensional direction is performed by use of the above expression (2). In the above calculation, the distortion compensation coefficients at the both adjacent coordinates P and R are used. Thus, the interpolated value of the coordinate Q is obtained. Thereafter, interpolation calculations are successively performed with regard to the coordinates adjacent beneath.

Additionally, similar to the interpolation processing in the one-dimensional direction, when the distortion compensation coefficient at the adjacent coordinate is unchanged from the initial value, the above coefficient is not used. Instead, a distortion compensation coefficient at a coordinate not having the initial distortion compensation coefficient value in the two-dimensional direction is used. For example, in FIG. 4A, to obtain an interpolated value of the coordinate Q, if the distortion compensation coefficient at the coordinate R has an initial value, and if the distortion compensation coefficient at the coordinate S adjacent to the coordinate R in the two-dimensional direction has no initial value, the distortion compensation coefficient at the coordinate S is used, in place of the distortion compensation coefficient at the coordinate R. In other words, the "adjacent coordinate" in expression (2) also signifies a coordinate nearest to the coordinate to be interpolated on the either side thereof in the two-dimensional direction, among the coordinates not having the initial distortion compensation values in the two-dimensional direction. Exceptionally, with regard to the coordinate at either end in the two-dimensional direction (for example, coordinate T, U, Z shown in FIG. 4A), the distortion compensation coefficient is used intact even when the initial value is left unchanged. Also, the coordinates in the row of gradient 0 are used even when the initial values are left unchanged. With regard to the interpolation processing in the two-dimensional direction, the coordinates on the both ends in the two-dimensional direction (for example, the coordinates T, U, Z in FIG. 4A) and the coordinates in the row of gradient 0 (in the one-dimensional direction), interpolation calculation in the two-dimensional direction is not performed.

The interpolation calculations in the two-dimensional direction are carried out, for example, from the column on the left end side to the lower end direction from the coordinate P on the lower left end side, with the row of gradient 0 as a center. On completion of the interpolation calculations up to the last coordinate S excluding the coordinate T on the lowermost end, the processing proceeds from a coordinate V on the upper left side to the upper end direction. Thus, the interpolation calculations are performed to the last coordinate Y excluding the uppermost end coordinate Z. Subsequently, after being shifted successively to the columns on the right side, the interpolation calculations are carried out alternately on the rows of the lower end side and the rows of the upper end side, with the row having the gradient 0 as a center.

Preferably, the aforementioned interpolation calculations in the one-dimensional direction and the interpolation calculations in the two-dimensional direction are carried out in one-time interpolation processing. However, it may also be possible to perform either one thereof. Additionally, when only the interpolation calculations of the two-dimensional direction are performed, first, the interpolation calculations in the one-dimensional direction are performed for the row having the gradient 0. Thereafter, the interpolation calculations in the two-dimensional direction are performed. The reason is that the distortion compensation coefficient in the row having the gradient 0 functions as a criterion.

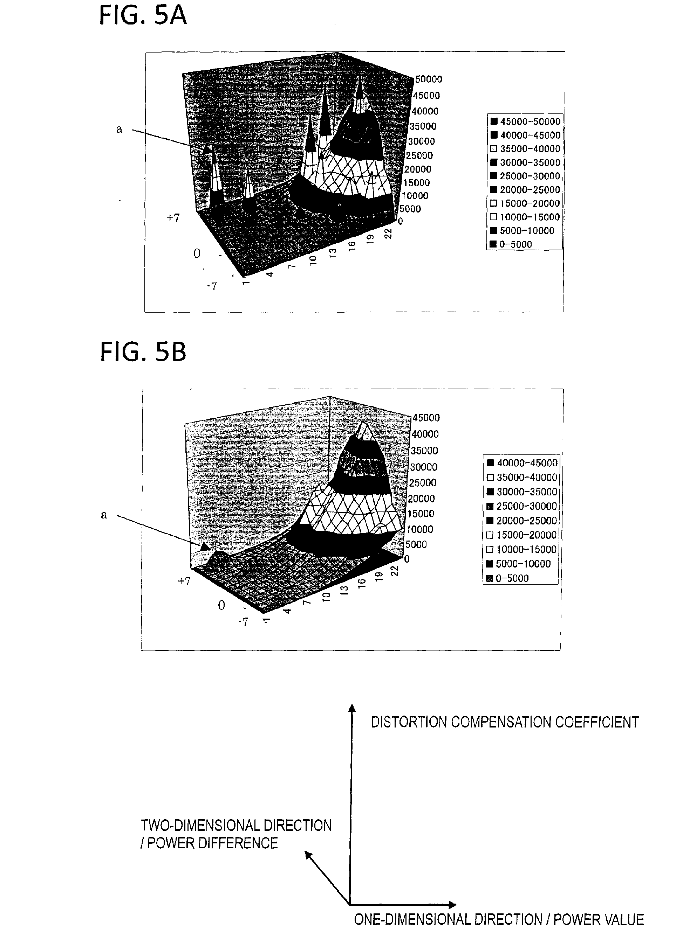

FIGS. 5A, 5B show diagrams schematically explaining interpolated values of the distortion compensation coefficients obtained through the interpolation calculations. FIG. 5A shows distortion compensation coefficients before the interpolation stored in memory (LUT) 42, and FIG. 5B shows distortion compensation coefficients after the interpolation to be stored in memory (LUT) 42. In FIGS. 5A, 5B, the one-dimensional direction represents transmission signal power values, and the two-dimensional direction represents the power difference between the transmission signals and the feedback signals, and the Z direction (vertical axis) represents distortion compensation coefficient values.

Since distortion compensation coefficients are closely correlated with coefficients adjacent thereto, a distortion compensation coefficient (for example, a reference symbol 'a' shown in FIG. 5A) having a prominently large value as compared with adjacent distortion compensation coefficient values in the surrounding coordinate is likely to include a large error. However, by performing interpolation calculations, the distortion compensation coefficient values come to have closer correlation with the adjacent distortion compensation coefficients, as shown in FIG. 5B, and a shortened convergence time becomes obtainable.

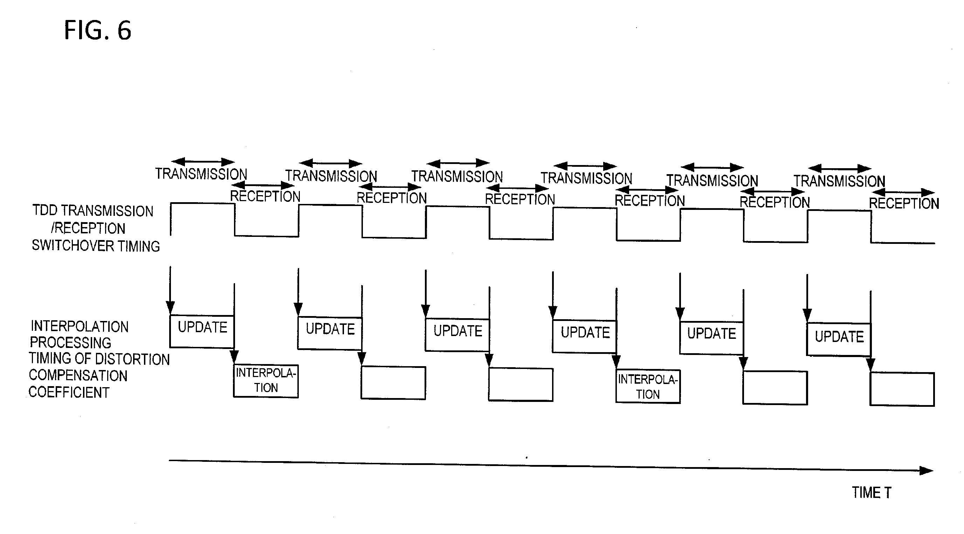

Fig. 6 is a diagram illustrating a timing chart of the update processing and the interpolation processing of the distortion compensation coefficient in the TDD scheme. In the TDD scheme having an alternately switched transmission/reception period, distortion compensation calculator 41 calculates the distortion compensation coefficient based on the transmission signal and the feedback signal, and updates the distortion compensation coefficient stored in memory (LUT) 42. Further, in the reception period, since there is neither signal transmission nor the distortion compensation coefficient calculation based on the transmission signal and the feedback signal, the above-mentioned interpolation calculations are carried out by utilizing the above reception period.

When the interpolation calculations with regard to the distortion compensation coefficients for the entire coordinates in memory (LUT) 42 are not completed in one reception period, the calculations for the remaining portion are carried out in the next reception period.

Further, the interpolation processing is not carried out repetitively at any time. When one-time interpolation processing, that is, interpolation calculations for the distortion compensation coefficients in the entire coordinates of memory (LUT) 42 is completed once, thereafter for a certain period, the interpolation processing is not performed. The reason is that if the calculations are performed repetitively at all times, the distortion compensation coefficient becomes too smooth, which undesirably causes a deteriorated distortion characteristic. For example, only one-time interpolation processing is carried out in a first reception period after the start of communication (or a reception period in the second or subsequent frame as needed). Alternatively, the interpolation processing is executed intermittently. As described earlier, the first-time interpolation processing is carried out in the first reception period after the start of communication (or a reception period in the second or later frames as required). When second-time interpolation processing is to be performed, for example, the processing is performed after the distortion compensation coefficient becomes a converged state. Thereafter, the processing is performed at intervals of a certain period. By performing after the convergence, it is possible to improve the stability of the distortion compensation coefficient further.

The aforementioned interpolation processing of the distortion compensation coefficient according to the present embodiment is not limited to radio transmission systems using the TDD scheme. The above processing is also applicable to a scheme in which simultaneous transmission and reception are performed continuously, such as the FDD scheme enabling simultaneous transmission and reception by use of different transmission and reception frequencies.

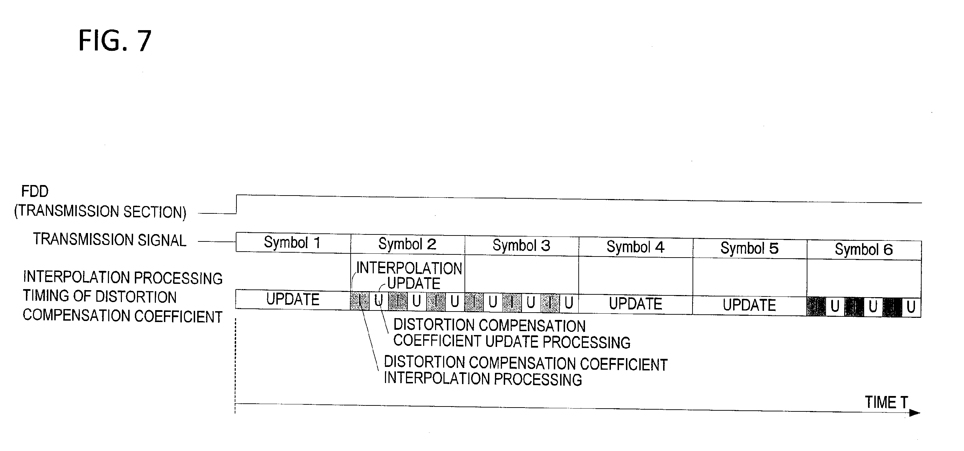

FIG. 7 is a diagram illustrating a timing chart of the update processing and the interpolation processing of the distortion compensation coefficient in the FDD scheme in which continuous transmission is carried out. With regard to the update processing and the interpolation processing, an update processing period and an interpolation processing period are switched alternately in the transmission periods of predetermined symbols (symbols 2, 3 and 6 in FIG. 7). By this, both the update processing and the interpolation processing can be performed in the transmission period of one symbol. Since there is a case that a difference in the transmission signal levels (power values) is produced symbol-by-symbol, preferably the update processing is performed throughout the entire symbol periods (transmission period for all symbols). However, by assigning an update processing period and an interpolation processing period alternately in one symbol period, it becomes possible to perform necessary update processing, as well as the interpolation processing.

In FIG. 7, the update processing and the interpolation processing are switched by dividing one symbol period into six. However, embodiments of the present invention are not limited to the division into six, but may use any arbitrary division number such as 2 and 4. Also, the symbol periods for performing the interpolation processing are provided intermittently. For example, in the exemplary case of FIG. 7, the interpolation processing is performed in consecutive two (2) symbol periods (symbols 2 and 3) among four (4) symbol periods (symbols 2 through 5), whereas the interpolation processing is not performed in the next 2 symbol periods (symbols 4 and 5). Further, the next consecutive 2 symbol periods [symbols 6 and 7 (not shown)] become symbol periods in which the interpolation processing is performed again.

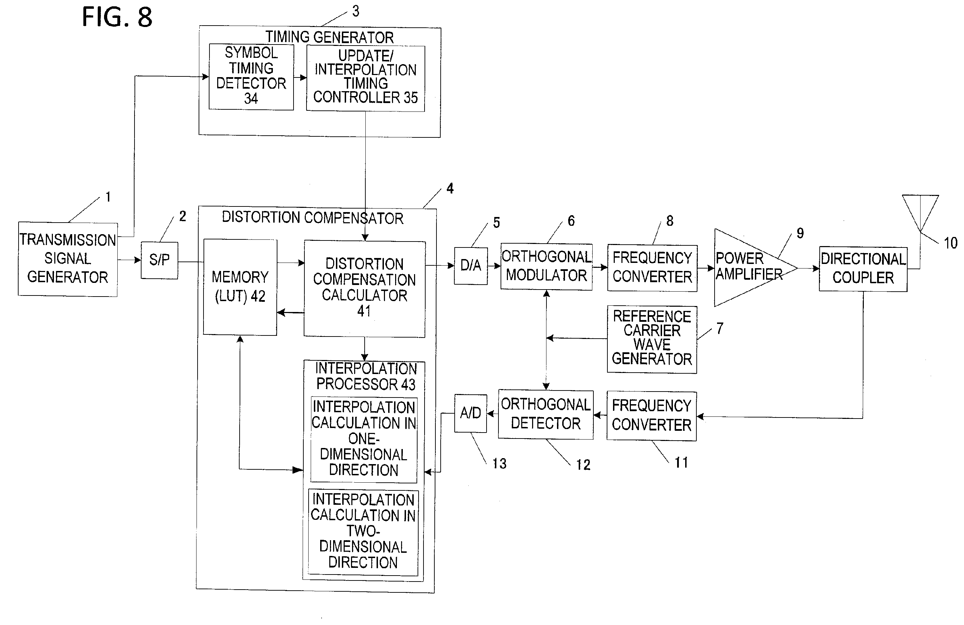

FIG. 8 is a diagram illustrating a second exemplary configuration of the radio transmission apparatus according to the present embodiment, which is an exemplary configuration to correspond to the timing chart shown in FIG. 7. As compared to the first exemplary configuration, it is not necessary for a timing generator 3 to detect switchover timing between the transmission period and the reception period, nor to detect a preamble period. A symbol timing detector 34 detects the symbol timing, and an update/interpolation timing controller 35 decides whether the detected symbol timing is a symbol period assigned to perform interpolation processing, according to preset period information for the interpolation processing to be performed. When it is a symbol period to perform the interpolation processing, a switchover signal to divide the symbol period is output according to a preset division number. Namely, in an update processing period, a distortion compensation calculator 41 performs update processing of the distortion compensation coefficients based on the transmission signals (symbols) and the feedback signals, whereas an interpolation processor 43 suspends the interpolation processing of the distortion compensation coefficients. In the interpolation processing period, interpolation processor 43 performs the interpolation processing of the distortion compensation coefficients, whereas distortion compensation calculator 41 suspends the update processing of the distortion compensation coefficients.

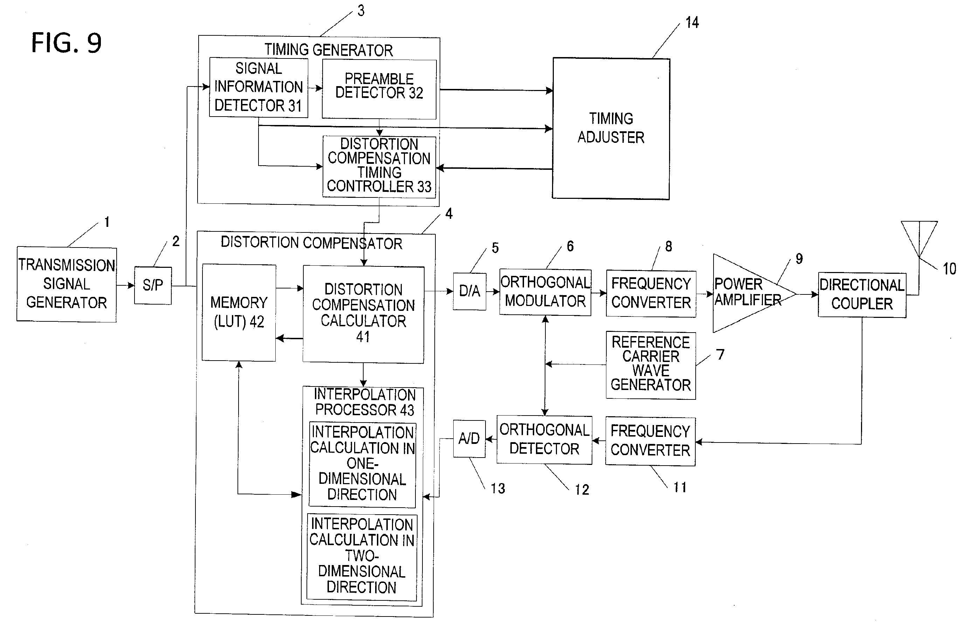

FIG. 9 is a diagram illustrating a third exemplary configuration of the radio transmission apparatus according to the present embodiment. As compared with the first exemplary configuration shown in FIG. 1, in the third exemplary configuration, a timing adjuster 14 is further provided for adjusting an output timing of a distortion compensation coefficient update timing signal. Timing adjuster 14 controls to shift the output timing (ON timing) of the distortion compensation coefficient update timing signal with a certain time interval width in each transmission period. Thus, it becomes possible to output the distortion compensation coefficient update timing signal at timing being delayed further than the timing after the lapse of a certain period from the transmission period start timing (preamble transmission end timing). By shifting the output timing of the distortion compensation coefficient update timing signal by the certain interval width in each transmission period, it is possible to suppress the growth of an error component in the distortion compensation coefficient. Also, it is possible to suppress spurious effects produced by the error component and a phenomenon of overall noise floor rise. Thus, better distortion compensation becomes obtainable. The procedure of the above timing adjustment processing by timing adjuster 14 will be described later.

When acquiring a transmission signal for updating the coefficient continuously at the same timing after the lapse of a certain time from the transmission period start timing (after the completion of preamble transmission), if the transmission signal is pattern data (such as synchronization pattern, test data and dummy data), acquisition of similar data having substantially no fluctuations in the amplitude and phase continues. If the update processing of the distortion compensation coefficient is repeated by substantially the same data, an error component accumulates in the distortion compensation coefficient of a particular range. This produces an inappropriate and deteriorated distortion compensation characteristic. Further, because of the above characteristic deterioration, the overall noise floor rises, which is especially noticeable in a portion corresponding to low power in the LUT. Using transmission signals having a variety of amplitudes and phases for distortion compensation update processing, the distortion compensation coefficient is updated randomly in an average manner. Accordingly, it is possible to avoid the above effects.

Additionally, by performing the aforementioned interpolation processing upon the distortion compensation coefficient to suppress an error component, the distortion compensation coefficient can be smoothed also, and spurious effects and the overall noise floor rise can be suppressed by the smoothed amount. Accordingly, by using both the interpolation processing and the timing adjustment processing described above, it becomes possible to suppress error components more effectively.

As described above, if the interpolation processing is carried out excessively, even a distortion compensation coefficient originally corresponding to the peak point is smoothed. This undesirably may cause a deteriorated high-power transmission function as a transmission amplifier. Therefore, it is particularly effective to apply the aforementioned timing adjustment processing in a case where spurious effects of pattern data cannot be sufficiently removed only by the interpolation processing.

In the exemplary third configuration, by means of the timing adjustment processing by timing adjuster 14, the output timing of the distortion compensation coefficient update timing signal is shifted by a certain interval width in each transmission period. Thus, data acquisition timing for use in updating the distortion compensation coefficient is shifted. By this, it is possible to acquire transmission signals having a variety of (moderately varying) amplitudes and phases, update the distortion compensation coefficient randomly in average, suppress the growth of an error component, and avoid spurious effects.

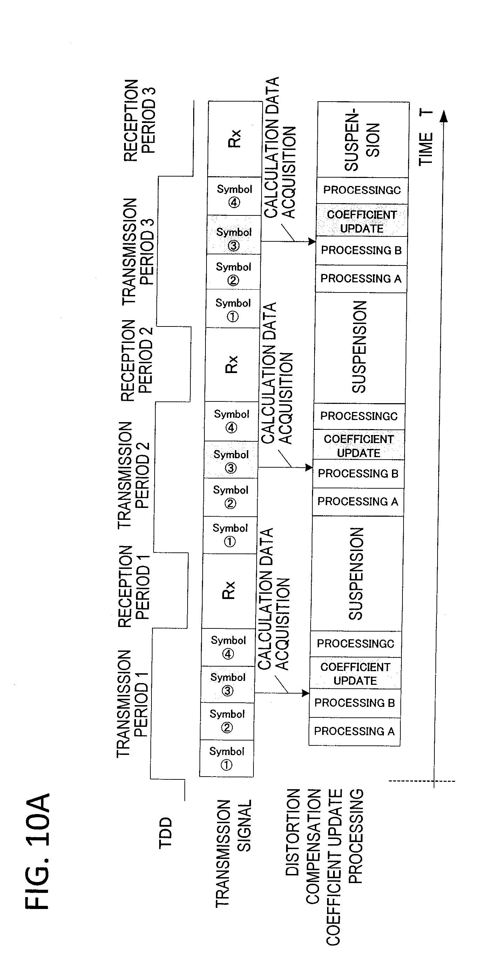

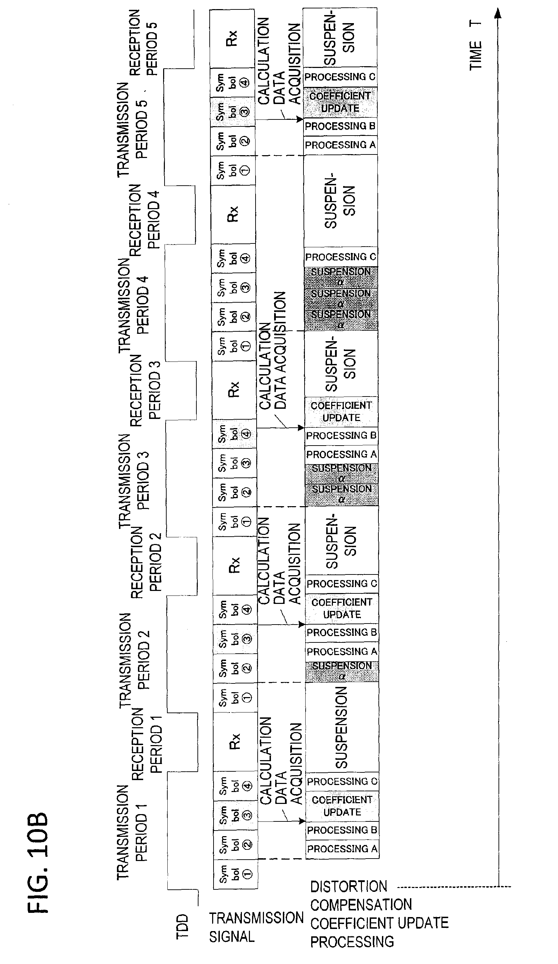

FIGS. 10A, 10B show timing charts to explain timing adjustment processing in the third exemplary configuration. The distortion compensation coefficient update processing includes element processing of, for example, processing A, processing B, coefficient update processing and processing C in the order of processing sequence. A transmission signal data is acquired at the start timing of the coefficient update processing.

FIG. 10A shows distortion compensation coefficient update processing timing when the timing adjustment processing is not performed by timing adjuster 14. FIG. 10B shows distortion compensation coefficient update processing timing when the timing adjustment processing is performed by timing adjuster 14. In FIG. 10A, the distortion compensation coefficient update processing is started every time at the same timing after the lapse of a certain time from the start of the transmission period (after the completion of transmission of the top symbol) throughout the entire transmission periods. In this case, the processing A, the processing B, the "coefficient update", and the processing C are completed within one transmission period, and processed at the same timing in every transmission period. The processing A, B and C are processing related to the distortion compensation coefficient update processing. Also, the "coefficient update" is processing to obtain and update the distortion compensation coefficient through calculation based on the data acquired from the transmission signal at the start timing thereof. Accordingly, the timing to acquire the data for calculation performed in the "coefficient update" becomes identical in each transmission period.

In contrast, in FIG. 10B, to shift the start timing of the distortion compensation coefficient update processing in each transmission period, a predetermined suspension time is provided, in addition to the predetermined timing a certain time after the transmission period start timing (after the completion of transmission of the top symbol). Thus, the distortion compensation coefficient update processing is started at a timing after the lapse of the suspension time.

The suspension time is made to vary for each transmission period (including a case of no suspension time). Denoting a unit duration of the suspension time to be $\alpha$, as shown in the figure, there are set no suspension time for a transmission period 1, a suspension time $\alpha$ for a transmission period 2, a suspension time $2\alpha$ for a transmission period 3, and a suspension time $3\alpha$ for a transmission period 4. By this, the start timing of the distortion compensation coefficient update processing is shifted by a time $\alpha$ in each transmission period. Also, the data acquisition timing in the transmission period is shifted in each transmission period. In a transmission period 5, the suspension time is returned to zero. A possible number of times of shifts is obtained in advance from the length of the transmission period and the suspension time. The start timing is shifted in each transmission period. On reaching the possible number of times of shifts, the process is returned to no suspension time. Then, the shift of the suspension time on the basis of a unit time $\alpha$ is repeated. The length of the time $\alpha$ can properly be set to the extent that the amplitude variation in the acquired data disperses randomly.

If the start timing of the distortion compensation coefficient update processing is delayed due to the insertion of the suspension time, for example, as in the transmission period 3, the entire processing of the distortion compensation coefficient update processing may not be completed before the transmission period end timing. In such a case, the remaining processing (processing C) is processed in the subsequent transmission period (transmission period 4) . Also, as shown by the transmission period 3, as to the processing which is in progress at the transmission period end timing (the coefficient update processing), the processing is continued in the subsequent reception period.

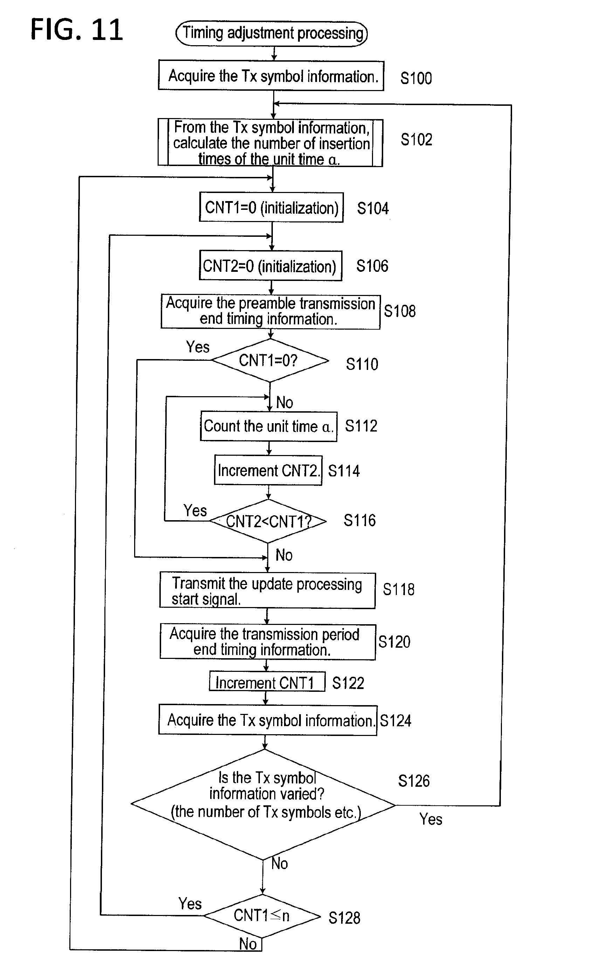

FIG. 11 is a processing flowchart of timing adjuster 14. Timing adjuster 14 acquires transmission (Tx) symbol information detected by signal information detector 31 (S100), obtains the transmission period length based on the above information, and calculates the possible number (n) of insertion times of the preset suspension unit time $\alpha$ (i.e. the possible number of times of shift) (S102). Then, timing adjuster 14 initializes the number of insertion counts (CNT1) in one transmission period (hereafter expressed as count CNT1) and the number of really inserted counts (CNT2) in one transmission period (hereafter expressed as real count CNT2) to zeroes (S104, S106). The count CNT1 is the number of unit times $\alpha$ to be set in each transmission period, signifying that the greater the count CNT1 is, the longer the suspension time becomes, causing the delayed start of the distortion compensation coefficient update processing. CNT1=0 is a case of no suspension time.

When timing adjuster 14 acquires preamble transmission end timing information with regard to each transmission period from preamble detector 32 (S108), timing adjuster 14 decides whether the count CNT1=0 (S110). If Yes, the process proceeds to the processing of the step S120 and after, which will be described later. If No, timing adjuster 14 measures the lapse of the unit time $\alpha$ (S112), and increments the real count CNT2 by one each time the unit time $\alpha$ elapses (S114). Timing adjuster 14 then compares the count CNT1 with the real count CNT2 (S116). If the incremented CNT2 is smaller than the set CNT1, timing adjuster 14 measures the lapse of the unit time $\alpha$ again (S112), and repeats the above measurement of the unit time $\alpha$ until the real count CNT2 reaches the count CNT1. The start timing of the distortion compensation coefficient update processing is shifted by the amount of the measured lapse of the unit time $\alpha$.

When the real count CNT2 reaches the count CNT1, an update processing start signal is transmitted to distortion compensation timing controller 33 (S118). On receiving the update processing start signal, distortion compensation timing controller 33 outputs a distortion compensation coefficient update timing signal. Thereby the distortion compensation coefficient update processing is started. Thereafter, on acquiring transmission period end timing information from preamble detector 32 (S120), distortion compensation timing controller 33 increments the count CNT1 by one (S122). By incrementing the count CNT1, the start timing of the distortion compensation coefficient update processing is further delayed by the unit time $\alpha$.

If the count CNT1 after being incremented is not greater than the possible number (n) of insertion times (S128), in the subsequent transmission period, the process returns to step S106. After the real count CNT2 is initialized and preamble transmission end timing information is acquired (S108), then the operation from steps S110 through S128 is repeated. If the count CNT1 after being incremented exceeds the possible number (n) of insertion times (S128), in the subsequent transmission period, both the count CNT1 and the real count CNT2 are initialized (S104, S106) . After the preamble transmission end timing information is acquired (S108), the operation from steps S110 through S128 is repeated.

In addition, the processing in steps S124 and S126 acquires transmission (Tx) symbol information in each transmission period (S124), and confirms the transmission period length. When the transmission period length is varied (S126), the process is returned to step S102. Then, the possible number (n) of insertion times is recalculated, and the processing proceeds to step S104 and thereafter. However, usually, the transmission period length is not varied halfway.

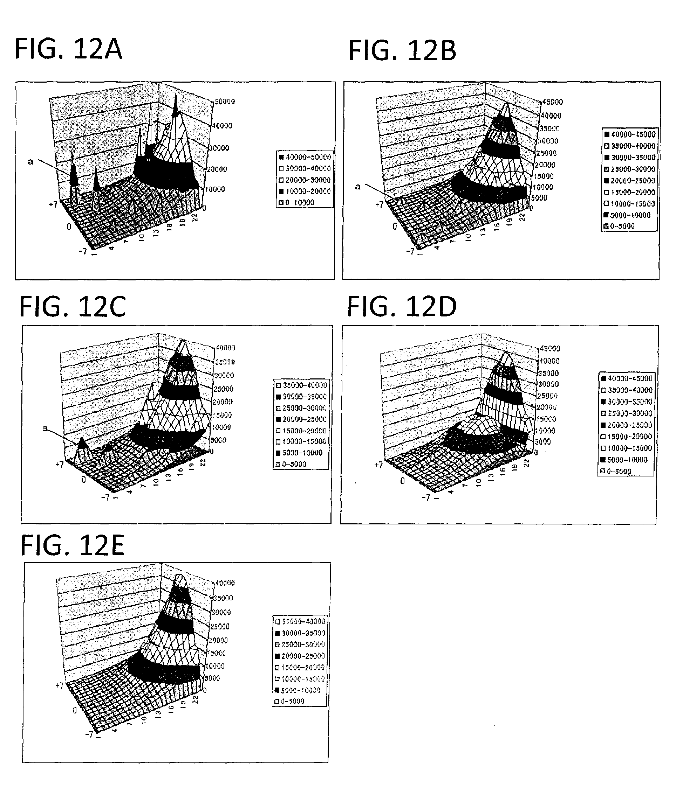

FIGS. 12A through 12E are diagrams explaining the distortion compensation coefficients on which update processing is performed in the third exemplary configuration. FIG. 12A shows distortion compensation coefficients before interpolation stored in memory (LUT) 42, similar to FIG. 5A. Due to the cases of small number of update times and unstable operation of an RF circuit, there is a growth of a distortion compensation coefficient having a prominently large value (hereafter referred to as error component), as compared to the distortion compensation coefficients in the surrounding adjacent coordinates (for example, reference symbols 'a' in FIG. 12A). As a result, the above error component causes the unnecessary spurious signals and the phenomenon of overall noise floor rise.

Similar to FIG. 5B, FIGS. 12B, 12C show distortion compensation coefficients after the interpolation processing. In each case, an appropriate number of times of interpolation processing are performed, and the error component (reference symbol 'a') is greatly suppressed. However, in FIG. 12C, a greater error component than in FIG. 12B remains partially. As shown in FIG. 12C, a relatively large error may possibly remain when the number of times of interpolation processing is excessively small, or when a pattern data such as having a small amplitude variation is used for update processing. Here, if excessive interpolation processing is made to suppress the error component, as shown in FIG. 12D, the distortion compensation coefficient becomes too smoothed, thereby causing a deteriorated distortion characteristic. In this case, the distortion compensation coefficient corresponding to the peak point is also smoothed, causing the degradation of a high output power transmission function as a transmission amplifier.

FIG. 12E shows distortion compensation coefficients on which update processing is performed by applying the processing of timing adjuster 14 in the third exemplary configuration. As compared to the cases in FIGS. 12B, 12C, the error component is substantially suppressed. Through the processing of timing adjuster 14, the start timing of the distortion compensation coefficient update processing is shifted in each transmission period. Thus, the growth of the error component can be suppressed, and the generated error components can substantially be suppressed through moderate interpolation processing.

The radio transmission apparatus according to the present invention is applicable to a base station or a mobile station in a TDD or FDD-based radio communication system.

The foregoing description of the embodiments is not intended to limit the invention to the particular details of the examples illustrated. Any suitable modification and equivalents may be resorted to within the scope of the invention. All features and advantages of the invention which fall within the scope of the invention are covered by the appended claims.

**Claims**

1. A radio transmission apparatus for amplifying a transmission signal by an amplifier and transmitting in a transmission period alternately switched with a reception period, comprising:

   a timing detector detecting start timing and end timing of the transmission period;
   amemorystoringadistortioncompensationcoefficient for compensating a distortion characteristic of the amplifier; and
   a distortion compensator executing distortion compensation processing to the transmission signal during a period from the start timing to the end timing based on the distortion compensation coefficient stored in the memory, calculating the distortion compensation coefficient during a period from predetermined timing after a certain time elapsing from the start timing to the end timing based on the distortion-compensated transmission signal being input to the amplifier and a feedback signal from the amplifier, and updating the distortion compensation coefficient stored in the memory to the calculated distortion compensation coefficient.

2. The radio transmission apparatus according to claim 1,
   wherein the predetermined timing after the certain time elapsing from the start timing is a timing after the transmission of a preamble signal included in the top of the transmission signal.

3. The radio transmission apparatus according to claim 1 or 2,
   wherein the memory stores the distortion compensation coefficient in correspondence to a variable related to the transmission signal, and
   wherein the radio transmission apparatus further includes an interpolation processor performing interpolation calculation using a distortion compensation coefficient corresponding to a predetermined variable value and distortion compensation coefficients corresponding to variable values adjacent to the predetermined variable value, so as to obtain an interpolated value of the distortion compensation coefficient corresponding to the predetermined variable value, and executing interpolation processing to update the distortion compensation coefficient corresponding to the predetermined variable value stored in the memory to the interpolated value.

4. The radio transmission apparatus according to claim 3,
wherein the interpolation processor performs calculation to execute the interpolation processing in the reception period only.

5. The radio transmission apparatus according to claim 3,
wherein the interpolation processor executes the interpolation processing intermittently in the reception period.

6. The radio transmission apparatus according to claim 3, 4, or 5,
wherein the variable includes a first variable which is a transmission signal power value and a second variable which is a power difference between the transmission signal and the feedback signal, and
wherein the interpolation processor executes the interpolation processing with regard to either one or both of the first variable and the second variable.

7. A radio transmission apparatus amplifying a transmission signal by an amplifier and transmitting in a transmission period alternately switched with a reception period, comprising:

a timing detector detecting start timing and end timing of the transmission period;
amemorystoringadistortioncompensationcoefficient for compensating a distortion characteristic of the amplifier in correspondence to a variable related to the transmission signal;
a distortion compensator executing distortion compensation processing to the transmission signal during a period from the start timing to the end timing based on the distortion compensation coefficient stored in the memory, calculating the distortion compensation coefficient based on the distortion-compensated transmission signal being input to the amplifier and a feedback signal from the amplifier, and updating the distortion compensation coefficient stored in the memory to the calculated distortion compensation coefficient; and
an interpolation processor performing interpolation calculation using a distortion compensation coefficient corresponding to a predetermined variable value and distortion compensation coefficients corresponding to variable values adjacent to the predetermined variable value, so as to obtain an interpolated value of the distortion compensation coefficient corresponding to the predetermined variable value, and executing interpolation processing to update the distortion compensation coefficient corresponding to the predetermined variable value stored in the memory to the interpolated value.

8. The radio transmission apparatus according to claim 7,
wherein the interpolation processor performs calculation to execute the interpolation processing in the reception period only.

9. The radio transmission apparatus according to claim 7 or 8,
wherein the variable includes a first variable which is a transmission signal power value and a second variable which is a power difference between the transmission signal and the feedback signal, and
wherein the interpolation processor executes the interpolation processing with regard to the first variable and the second variable, respectively.

10. The radio transmission apparatus according to claim 7 or 8,
wherein the interpolation processor executes the interpolation processing intermittently.

11. A radio transmission apparatus transmitting a transmission signal after amplifying by an amplifier, comprising:

amemorystoringadistortioncompensationcoefficient for compensating a distortion characteristic of the amplifier, in correspondence to a variable related to the transmission signal;
a distortion compensator executing distortion compensation processing to the transmission signal based on the distortion compensation coefficient stored in the memory, calculating the distortion compensation coefficient based on the distortion-compensated transmission signal being input to the amplifier and a feedback signal from the amplifier, and executing update processing to update the distortion compensation coefficient stored in the memory to the calculated distortion compensation coefficient; and

an interpolation processor performing interpolation calculation using a distortion compensation coefficient corresponding to a predetermined variable value and distortion compensation coefficients corresponding to variable values adjacent to the predetermined variable value, so as to obtain an interpolated value of the distortion compensation coefficient corresponding to the predetermined variable value, and executing interpolation processing to update the distortion compensation coefficient corresponding to the predetermined variable value stored in the memory to the interpolated value.

**12.** A radio transmission apparatus amplifying a transmission signal by an amplifier and transmitting in a transmission period alternately switched with a reception period, comprising:

a timing detector detecting start timing and end timing of the transmission period;
amemorystoringadistortioncompensationcoefficient for compensating a distortion characteristic of the amplifier in correspondence to a variable related to the transmission signal;
a distortion compensator executing distortion compensation processing to the transmission signal during a period from the start timing to the end timing based on the distortion compensation coefficient stored in the memory, calculating the distortion compensation coefficient based on the distortion-compensated transmission signal being input to the amplifier and a feedback signal from the amplifier, and executing update processing to update the distortion compensation coefficient stored in the memory to the calculated distortion compensation coefficient; and
a timing adjuster varying predetermined timing to make the distortion compensator start the update processing in the transmission period on the basis of each transmission period.

**13.** The radio transmission apparatus according to claim 12,
wherein the timing adjuster successively delays the predetermined timing increased on a per unit time basis from initial set timing in each transmission period, returns to the initial set timing after delayed for a predetermined number of times, and repeats the delays on a per unit time basis from the initial set timing again.

**14.** The radio transmission apparatus according to claim 12,
wherein the predetermined timing is a timing after the lapse of a certain time from the start timing.

**15.** The radio transmission apparatus according to claim 13,
wherein the memory stores the distortion compensation coefficient in correspondence to a variable related to the transmission signal, and
wherein the radio transmission apparatus further includes an interpolation processor performing interpolation calculation using a distortion compensation coefficient corresponding to a predetermined variable value and distortion compensation coefficients corresponding to variable values adjacent to the predetermined variable value, so as to obtain an interpolated value of the distortion compensation coefficient corresponding to the predetermined variable value, and executing interpolation processing to update the distortion compensation coefficient corresponding to the predetermined variable value stored in the memory to the interpolated value.

FIG. 1

# FIG. 2

TRANSMISSION LEVEL

1 FRAME

TRANSMISSION PERIOD

RECEPTION PERIOD

SECTION OF VARIED TRANSMISSION LEVEL

DISTORTION COMPENSATION COEFFICIENT UPDATE PERIOD

TIME

DISTORTION COMPENSATION COEFFICIENT UPDATE TIMING SIGNAL

DISTORTION COMPENSATION OPERATION TIMING SIGNAL

EP 2 051 390 A2

EP 2 051 390 A2

FIG. 3A

GRADIENT 0

TWO-DIMENSIONAL
DIRECTION

ONE-DIMENSIONAL
DIRECTION

FIG. 3B

INTERPOLATION PROCESSING SECTION

INTERPOLATED VALUE OF
DISTORTION
COMPENSATION
DISTORTION COEFFICIENT
COMPENSATION
COEFFICIENT

INITIAL
VALUE

ONE-DIMENSIONAL
DIRECTION

EP 2 051 390 A2

# FIG. 4A

GRADIENT 0

TWO-DIMENSIONAL
DIRECTION

②④

Z
Y
X
W
V
A B C D E F G H
P
Q
R
S
T U

①③

n

n−1

ONE-DIMENSIONAL
DIRECTION

# FIG. 4B

INTERPOLATION PROCESSING SECTION

INTERPOLATED VALUE OF
DISTORTION COMPENSATION
COEFFICIENT

DISTORTION COMPENSATION
COEFFICIENT

INITIAL
VALUE

TWO-DIMENSIONAL
DIRECTION

## FIG. 5A

## FIG. 5B

DISTORTION COMPENSATION COEFFICIENT

TWO-DIMENSIONAL DIRECTION
/ POWER DIFFERENCE

ONE-DIMENSIONAL DIRECTION / POWER VALUE

# FIG. 6

TDD TRANSMISSION /RECEPTION SWITCHOVER TIMING

TRANSMISSION RECEPTION TRANSMISSION RECEPTION TRANSMISSION RECEPTION TRANSMISSION RECEPTION TRANSMISSION RECEPTION TRANSMISSION RECEPTION

INTERPOLATION PROCESSING TIMING OF DISTORTION COMPENSATION COEFFICIENT

UPDATE INTERPOLA-TION UPDATE UPDATE UPDATE INTERPOLA-TION UPDATE UPDATE

TIME T

# FIG. 7

FDD
(TRANSMISSION SECTION)

TRANSMISSION SIGNAL

| Symbol 1 | Symbol 2 | Symbol 3 | Symbol 4 | Symbol 5 | Symbol 6 |
|---|---|---|---|---|---|

INTERPOLATION PROCESSING
TIMING OF DISTORTION
COMPENSATION COEFFICIENT

INTERPOLATION
UPDATE

| UPDATE | I U I U I U | I U I U I U | UPDATE | UPDATE | U U U |
|---|---|---|---|---|---|

DISTORTION COMPENSATION
COEFFICIENT UPDATE PROCESSING

DISTORTION COMPENSATION COEFFICIENT
INTERPOLATION PROCESSING

TIME T

EP 2 051 390 A2

FIG. 8

TIMING GENERATOR — 3

| SYMBOL TIMING DETECTOR 34 | UPDATE/ INTERPOLATION TIMING CONTROLLER 35 |

TRANSMISSION SIGNAL GENERATOR — 1

S/P — 2

DISTORTION COMPENSATOR — 4

MEMORY (LUT) 42

DISTORTION COMPENSATION CALCULATOR 41

INTERPOLATION PROCESSOR 43

INTERPOLATION CALCULATION IN ONE-DIMENSIONAL DIRECTION

INTERPOLATION CALCULATION IN TWO-DIMENSIONAL DIRECTION

D/A — 5

ORTHOGONAL MODULATOR — 6

FREQUENCY CONVERTER — 8

POWER AMPLIFIER — 9

DIRECTIONAL COUPLER

10

REFERENCE CARRIER WAVE GENERATOR — 7

A/D — 13

ORTHOGONAL DETECTOR — 12

FREQUENCY CONVERTER — 11

FIG. 9

# FIG. 10A

EP 2 051 390 A2

# FIG. 10B

EP 2 051 390 A2

| TRANSMISSION PERIOD 1 | RECEPTION PERIOD 1 | TRANSMISSION PERIOD 2 | RECEPTION PERIOD 2 | TRANSMISSION PERIOD 3 | RECEPTION PERIOD 3 | TRANSMISSION PERIOD 4 | RECEPTION PERIOD 4 | TRANSMISSION PERIOD 5 | RECEPTION PERIOD 5 |

TDD

TRANSMISSION SIGNAL

| Symbol ① | Symbol ② | Symbol ③ | Symbol ④ | Rx | Symbol ① | Symbol ② | Symbol ③ | Symbol ④ | Rx | Symbol ① | Symbol ② | Symbol ③ | Symbol ④ | Rx | Symbol ① | Symbol ② | Symbol ③ | Symbol ④ | Rx | Symbol ① | Symbol ② | Symbol ③ | Symbol ④ | Rx |

CALCULATION DATA ACQUISITION

DISTORTION COMPENSATION COEFFICIENT UPDATE PROCESSING

PROCESSING A / PROCESSING B / COEFFICIENT UPDATE / PROCESSING C / SUSPENSION / SUSPENSION α / PROCESSING A / PROCESSING B / COEFFICIENT UPDATE / PROCESSING C / SUSPENSION / SUSPENSION α / SUSPENSION / PROCESSING A / PROCESSING B / COEFFICIENT UPDATE / SUSPENSION / SUSPENSION α / SUSPENSION α / SUSPENSION / PROCESSING C / SUSPENSION / PROCESSING A / PROCESSING B / COEFFICIENT UPDATE / PROCESSING C / SUSPENSION

TIME T

# FIG. 11

( Timing adjustment processing )

↓

| Acquire the Tx symbol information. | S100 |

↓

| From the Tx symbol information, calculate the number of insertion times of the unit time α. | S102 |

↓

| CNT1=0 (initialization) | S104 |

↓

| CNT2=0 (initialization) | S106 |

↓

| Acquire the preamble transmission end timing information. | S108 |

↓

Yes ← < CNT1=0? > S110

↓ No

| Count the unit time α. | S112 |

↓

| Increment CNT2. | S114 |

↓

Yes ← < CNT2<CNT1? > S116

↓ No

| Transmit the update processing start signal. | S118 |

↓

| Acquire the transmission period end timing information. | S120 |

↓

| Increment CNT1 | S122 |

↓

| Acquire the Tx symbol information. | S124 |

↓

< Is the Tx symbol information varied? (the number of Tx symbols etc.) > S126 → Yes

↓ No

Yes ← < CNT1≤n > S128

↓ No

## FIG. 12A

## FIG. 12B

## FIG. 12C

## FIG. 12D

## FIG. 12E

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007271270 A
- JP 2008119473 A
- JP HEI9153849 B

- JP 2002223171 A
- JP 2006197537 A
- JP 2006074539 A